# EUROPEAN PATENT APPLICATION

(11) **EP 4 578 713 A1**
(43) Date of publication of application: **02.07.2025**
(21) Application number: 24217339.1
(22) Date of filing: 04.12.2024
(51) Int. Cl.: B60L 53/16, B60L 53/18

(54) **CHARGING TERMINAL FIXING COMPONENT, TOP COVER ASSEMBLY, CHARGING TERMINAL COOLING BOX AND CHARGING SEAT**

(30) Priority: 06.12.2023 CN 202311668511
(71) Applicant: Tyco Electronics Technology (SIP) Ltd., Suzhou 215026 (CN); Tyco Electronics (Shanghai) Co., Ltd., Pilot Free Trade Zone Shanghai 200131 (CN)
(72) Inventor: Xia, Leilei, Shanghai,, 200233 (CN); Zhu, Fangyue, Shanghai,, 200233 (CN); Zhang, Qun, Suzhou,, 32 215123 (CN)
(74) Representative: Grünecker Patent- und Rechtsanwälte PartG mbB

(57) **Abstract**

The present invention discloses a charging terminal fixing component, a top cover assembly, a charging terminal cooling box, and a charging seat. The charging terminal fixing component comprises of a frame (129) adapted to be fixed to a charging terminal cooling box (1); and a fixing structure (120) which is formed on the top of the frame (129) for fixing a charging terminal (3) to the charging terminal cooling box (1). The fixing structure (120) comprises of a pair of side plates (121), with their bottom connected to the top of the frame (129); a pair of top plates (122) respectively connected to the top of the pair of side plates (121); and a pair of elastic buckles (123) respectively connected to the top of the pair of side plates (121). The pair of top plates (122) are adapted to rest against the top surface of a welding end (31) of the charging terminal (3) inserted between the pair of side plates (121), so that the bottom surface of the welding end (31) of the charging terminal (3) is in thermal contact with a top cover (11) of the charging terminal cooling box (1); the pair of elastic buckles (123) are used to respectively engage with a pair of snap slots (31a) on the welding end (31) of the charging terminal (3), to lock the welding end (31) of the charging terminal (3) to the top cover (11) of the charging terminal cooling box (1). In the present invention, the charging terminal fixing component fixes the charging terminal to the top cover of the charging terminal cooling box, so that the heat of the charging terminal can be quickly transferred to the cooling liquid inside the charging terminal cooling box through the top cover, thereby achieving rapid cooling of the charging terminal.

## Description

### CROSS-REFERENCE TO RELATED APPLICATION

This application claims the benefit of Chinese Patent Application No. CN202311668511.6 filed on December 6, 2023 in the State Intellectual Property Office of China, the whole disclosure of which is incorporated herein by reference.

### BACKGROUND OF THE INVENTION

### Field of the Invention

The present invention relates to a charging terminal fixing component, a top cover assembly comprising the charging terminal fixing component, a charging terminal cooling box comprising the top cover assembly, and a charging seat comprising the charging terminal cooling box.

### Description of the Related Art

In the prior art, the charging seat usually includes a charging seat housing, a charging terminal set in the charging seat housing, and a charging cable electrically connected to the charging terminal. In order to improve the charging speed, it is necessary to increase the charging current. Currently, the charging current requirement is as high as 600A, and it may be further increased to 1000A in the future. When this high current flows through the charging cable and charging terminal, it will cause a sharp rise in the temperature inside the charging seat housing and the temperature of the charging cable. In order to prevent excessive temperature rise, in the prior art, the diameter of the charging cable is usually increased, but this will increase the volume and weight of the charging seat product, and lead to higher costs.

### SUMMARY OF THE INVENTION

The present invention has been made to overcome or alleviate at least one aspect of the above mentioned disadvantages.

According to an aspect of the present invention, there is provided a charging terminal fixing component. The charging terminal fixing component comprises of a frame adapted to be fixed to a charging terminal cooling box; and a fixing structure which is formed on the top of the frame for fixing a charging terminal to the charging terminal cooling box. The fixing structure comprises of a pair of side plates, with their bottom connected to the top of the frame; a pair of top plates respectively connected to the top of the pair of side plates; and a pair of elastic buckles respectively connected to the top of the pair of side plates. The pair of top plates are adapted to rest against the top surface of a welding end of the charging terminal inserted between the pair of side plates, so that the bottom surface of the welding end of the charging terminal is in thermal contact with a top cover of the charging terminal cooling box. The pair of elastic buckles are used to respectively engage with a pair of snap slots on the welding end of the charging terminal, to lock the welding end of the charging terminal to the top cover of the charging terminal cooling box.

According to an exemplary embodiment of the present invention, the pair of top plates of the fixing structure are located between the pair of side plates and are spaced apart from each other by a predetermined distance, used to avoid a front end of a conductor of a charging cable welded to the welding end of the charging terminal.

According to another exemplary embodiment of the present invention, the pair of elastic buckles of the fixing structure are respectively located at one ends of the pair of top plates, and a spacing slot is formed between the elastic buckle and one end of the top plate to separate them.

According to another exemplary embodiment of the present invention, the elastic buckle has a main body that is flush with the top plate and a protruding portion that protrudes from the bottom of the main body, the protruding portion is used to engage with the snap slot on the welding end of the charging terminal.

According to another exemplary embodiment of the present invention, a guide slope inclined with the top plate is formed on the bottom of the elastic buckle to guide the welding end of the charging terminal to be inserted between the top cover of the charging terminal cooling box and the top plates.

According to another exemplary embodiment of the present invention, a wall recess is formed at the bottom of at least one of the pair of side plates, for joining with the edge of the top cover of the charging terminal cooling box, to increase the bonding strength between the charging terminal fixing component and the top cover of the charging terminal cooling box.

According to another exemplary embodiment of the present invention, the charging terminal fixing component comprises multiple fixing structures arranged side by side for fixing multiple charging terminals respectively.

According to another exemplary embodiment of the present invention, a mounting hole is formed in the frame to allow a connecting member to pass through, so that the frame can be fastened to the top surface of the charging terminal cooling box through the connecting member passing through the mounting hole.

According to another aspect of the present invention, there is provided a top cover assembly. The top cover assembly comprises of a top cover which is adapted to be installed on the top of a box body of a charging terminal cooling box to cover a top opening of the box body; and the above charging terminal fixing component which is directly formed onto the top cover by embedding injection molding. The charging terminal fixing component is used to fix the welding end of the charging terminal to the top surface of the top cover, so as to transfer the heat of the charging terminal to the cooling liquid inside the charging terminal cooling box through the top cover.

According to an exemplary embodiment of the present invention, the top surface of the frame of the charging terminal fixing component is joined to the bottom surface of the top cover, and a connection hole corresponding to the mounting hole on the frame is formed in the top cover, so that the top cover assembly can be fastened to the top surface of the box body of the charging terminal cooling box by a connection member passing through the mounting hole and the connection hole.

According to another exemplary embodiment of the present invention, the top cover is an insulation component that can conduct heat but cannot conduct electricity.

According to another exemplary embodiment of the present invention, the top cover is a ceramic component that can conduct heat but cannot conduct electricity.

According to another aspect of the present invention, there is provided a charging terminal cooling box. The charging terminal cooling box comprises of a box body which has an inner cavity for accommodating cooling liquid and a top opening; and the above top cover assembly installed on the top of the box body, for covering the top opening of the box body. The box body has a cooling core pipe joint and an inlet pipe joint communicated with the inner cavity, the inlet pipe joint is used to connect with an inlet pipe, and the cooling core pipe joint is used to connect with a cooling core pipe of a charging cable, so that the cooling liquid can flow through the charging terminal cooling box and the cooling core pipe of the charging cable to cool the charging terminal and the charging cable.

According to another exemplary embodiment of the present invention, the charging terminal cooling box further comprises a sealing ring which is installed on the top of the box body and surrounds the top opening of the box body. The sealing ring is compressed between the top cover and the box body of the charging terminal cooling box to seal the top opening of the box body.

According to another exemplary embodiment of the present invention, a flange portion is formed on the top surface of the box body to surround the top opening, and the frame of the charging terminal fixing component surrounds the flange portion; the sealing ring is installed and positioned in a annular gap between the flange portion of the box body and the frame of the charging terminal fixing component.

According to another exemplary embodiment of the present invention, a threaded hole is formed in the top surface of the box body of the charging terminal cooling box; the charging terminal cooling box further comprises a connecting member, which passes through the connecting hole in the top cover and the mounting hole in the charging terminal fixing component and is threaded into the threaded hole in the top surface of the box body to fasten the top cover assembly to the top surface of the box body.

According to another exemplary embodiment of the present invention, the top cover of the charging terminal cooling box is an insulation component that conducts heat but not electricity, and the box body of the charging terminal cooling box is an insulation component that cannot conducts heat and electricity.

According to another aspect of the present invention, there is provided a charging seat. The charging seat comprises of a housing; a charging terminal which is provided in the housing and has a flat welding end; a charging cable, one end of which extends into the housing and includes a cooling core pipe and a conductor; and the above charging terminal cooling box which is provided in the housing. The welding end of the charging terminal is fixed to the top surface of the top cover of the charging terminal cooling box by the charging terminal fixing component, and the front end of the conductor of the charging cable is welded to the top surface of the welding end of the charging terminal; the end portion of the cooling core pipe of the charging cable is connected to the cooling core pipe joint of the box body of the charging terminal cooling box, so that the cooling liquid can flow through the charging terminal cooling box and the cooling core pipe of the charging cable.

According to another exemplary embodiment of the present invention, the welding end of the charging terminal is located within the coverage area of the top opening of the box body of the charging terminal cooling box, so that the heat of the entire welding end can be transferred to the cooling liquid inside the charging terminal cooling box through the top cover.

According to another exemplary embodiment of the present invention, charging seat further comprises a heat shrink tube which is fitted and heat shrunk onto the end portion of the cooling core pipe and the cooling core pipe joint of the charging terminal cooling box to achieve a sealed connection between the cooling core pipe and the cooling core pipe joint.

According to another exemplary embodiment of the present invention, the charging seat further comprises an inlet pipe which is connected to the inlet pipe joint of the charging terminal cooling box, and is used to supply the cooling liquid to the charging terminal cooling box and the cooling core pipe of the charging cable.

In the aforementioned exemplary embodiments according to the present invention, the charging terminal fixing component fixes the charging terminal to the top cover of the charging terminal cooling box, so that the heat of the charging terminal can be quickly transferred to the cooling liquid inside the charging terminal cooling box through the top cover, thereby achieving rapid cooling of the charging terminal.

In addition, in the aforementioned exemplary embodiments according to the present invention, the charging terminal fixing component can fix the charging terminal to the top cover of the charging terminal cooling box in a detachable manner, so that the charging terminal can be easily fixed to the charging terminal cooling box and can be easily removed from the charging terminal cooling box, making it very convenient to use.

In addition, in the aforementioned exemplary embodiments according to the present invention, the charging terminal fixing component is directly formed onto the top cover of the charging terminal cooling box in an embedded injection molding manner, so that the charging terminal fixing component and the top cover are integrated and can be installed and fixed together to the box body of the charging terminal cooling box, simplifying the installation steps.

In addition, in the aforementioned exemplary embodiments according to the present invention, the welding end of the charging terminal is located in the coverage area of the top opening of the charging terminal cooling box, so that the heat of the entire welding end can be quickly transferred to the cooling liquid inside the cooling box through the top cover, thereby improving the cooling efficiency.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of a charging terminal cooling box according to an exemplary embodiment of the present invention when viewed from the bottom, in which the charging terminal and charging cable are shown;
Figure 2 shows an illustrative perspective view of a charging terminal cooling box according to an exemplary embodiment of the present invention when viewed from the top, in which the charging terminal and charging cable are shown;
Figure 3 shows an illustrative exploded view of a charging terminal cooling box, charging terminal, and charging cable according to an exemplary embodiment of the present invention;
Figure 4 shows a transverse sectional view of a charging terminal cooling box, charging terminal, and charging cable according to an exemplary embodiment of the present invention;
Figure 5 shows a longitudinal sectional view of a charging terminal cooling box, charging terminal, and charging cable according to an exemplary embodiment of the present invention;
Figure 6 shows a longitudinal sectional view of a charging terminal cooling box according to an exemplary embodiment of the present invention;
Figure 7 shows an illustrative perspective view of a charging terminal fixing component according to an exemplary embodiment of the present invention;
Figure 8 shows an illustrative perspective view of a charging terminal cooling box and charging terminal according to an exemplary embodiment of the present invention;
Figure 9 shows an illustrative perspective view of a charging terminal cooling box according to an exemplary embodiment of the present invention;
Figure 10 shows an illustrative perspective view of a charging terminal cooling box according to an exemplary embodiment of the present invention, with the top cover assembly opened;
Figure 11 shows an illustrative exploded view of a charging terminal cooling box according to an exemplary embodiment of the present invention; and
Figure 12 shows a longitudinal sectional view of a charging seat according to an exemplary embodiment of the present invention.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a charging terminal fixing component. The charging terminal fixing component comprises of a frame adapted to be fixed to a charging terminal cooling box; and a fixing structure which is formed on the top of the frame for fixing a charging terminal to the charging terminal cooling box. The fixing structure comprises of a pair of side plates, with their bottom connected to the top of the frame; a pair of top plates respectively connected to the top of the pair of side plates; and a pair of elastic buckles respectively connected to the top of the pair of side plates. The pair of top plates are adapted to rest against the top surface of a welding end of the charging terminal inserted between the pair of side plates, so that the bottom surface of the welding end of the charging terminal is in thermal contact with a top cover of the charging terminal cooling box. The pair of elastic buckles are used to respectively engage with a pair of snap slots on the welding end of the charging terminal, to lock the welding end of the charging terminal to the top cover of the charging terminal cooling box.

According to another general concept of the present invention, there is provided a top cover assembly. The top cover assembly comprises of a top cover which is adapted to be installed on the top of a box body of a charging terminal cooling box to cover a top opening of the box body; and the above charging terminal fixing component which is directly formed onto the top cover by embedding injection molding. The charging terminal fixing component is used to fix the welding end of the charging terminal to the top surface of the top cover, so as to transfer the heat of the charging terminal to the cooling liquid inside the charging terminal cooling box through the top cover.

According to another general concept of the present invention, there is provided a charging terminal cooling box. The charging terminal cooling box comprises of: a box body which has an inner cavity for accommodating cooling liquid and a top opening; and the above top cover assembly installed on the top of the box body, for covering the top opening of the box body. The box body has a cooling core pipe joint and an inlet pipe joint communicated with the inner cavity, the inlet pipe joint is used to connect with an inlet pipe, and the cooling core pipe joint is used to connect with a cooling core pipe of a charging cable, so that the cooling liquid can flow through the charging terminal cooling box and the cooling core pipe of the charging cable to cool the charging terminal and the charging cable.

According to another general concept of the present invention, there is provided a charging seat. The charging seat comprises of a housing; a charging terminal which is provided in the housing and has a flat welding end; a charging cable, one end of which extends into the housing and includes a cooling core pipe and a conductor; and the above charging terminal cooling box which is provided in the housing. The welding end of the charging terminal is fixed to the top surface of the top cover of the charging terminal cooling box by the charging terminal fixing component, and the front end of the conductor of the charging cable is welded to the top surface of the welding end of the charging terminal; the end portion of the cooling core pipe of the charging cable is connected to the cooling core pipe joint of the box body of the charging terminal cooling box, so that the cooling liquid can flow through the charging terminal cooling box and the cooling core pipe of the charging cable.

According to another general concept of the present invention, there is provided a charging terminal cooling box. The charging terminal cooling box comprises of: a box body which has an inner cavity for accommodating cooling liquid and a top opening; and a top cover which is installed on the top of the box body to cover the top opening of the box body. The top cover is used to make thermal contact with a welding end of a charging terminal fixed on it, in order to transfer the heat of the charging terminal to the cooling liquid inside the box body, the box body has a cooling core pipe joint and an inlet pipe joint that are communicated with the inner cavity, the inlet pipe joint is used to connect with an inlet pipe, and the cooling core pipe joint is used to connect with a cooling core pipe of a charging cable, so that the cooling liquid can flow through the charging terminal cooling box and the cooling core pipe of the charging cable to cool the charging terminal and the charging cable.

According to another general concept of the present invention, there is provided a charging seat. The charging seat comprises of a housing; a charging terminal which is provided in the housing and has a flat welding end; a charging cable, one end of which extends into the housing and includes a cooling core pipe and a conductor; and the above charging terminal cooling box which is provided in the housing. The welding end of the charging terminal is fixed to the top surface of the top cover of the charging terminal cooling box, and the front end of the conductor of the charging cable is welded to the top surface of the welding end of the charging terminal, the end portion of the cooling core pipe of the charging cable is connected to the cooling core pipe joint of the box body of the charging terminal cooling box, so that the cooling liquid can flow through the charging terminal cooling box and the cooling core pipe of the charging cable.

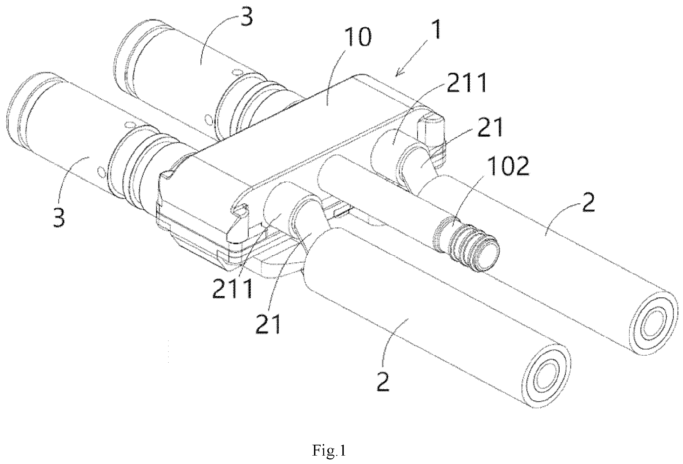

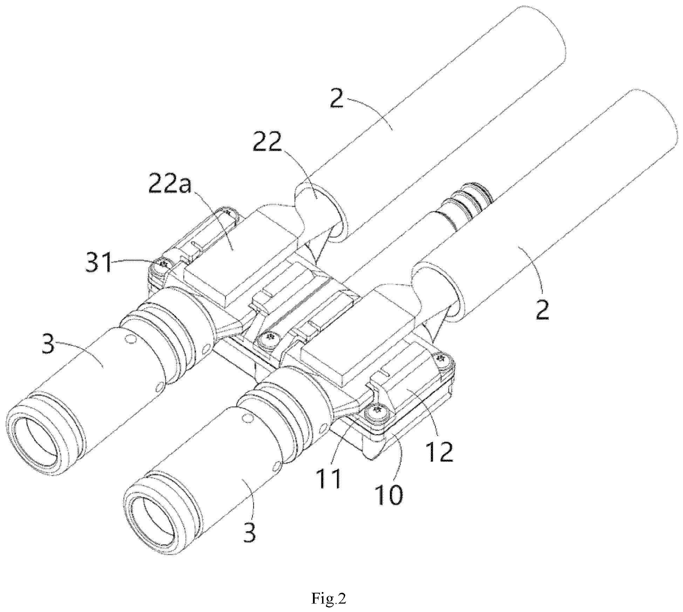

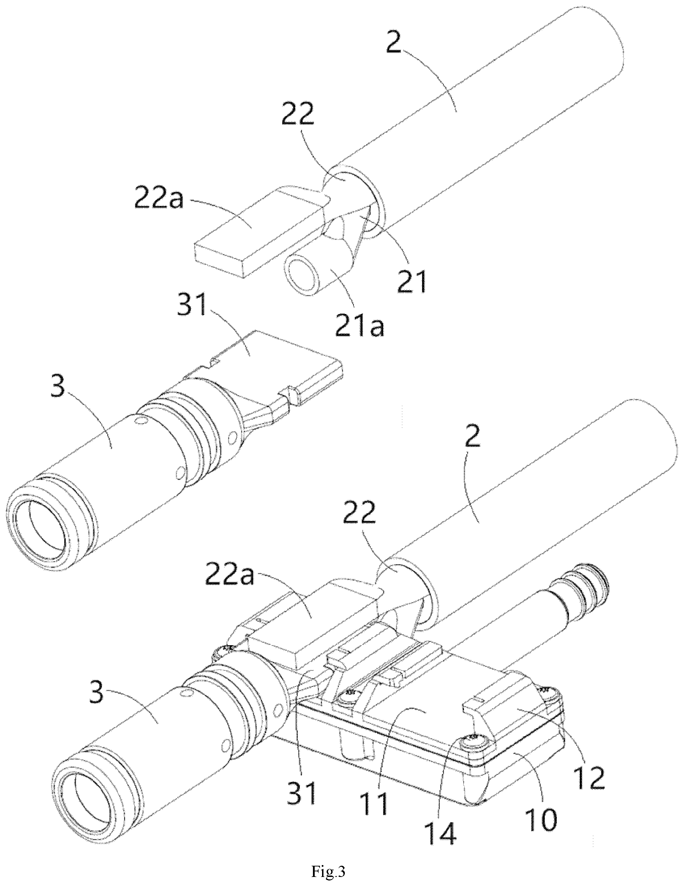

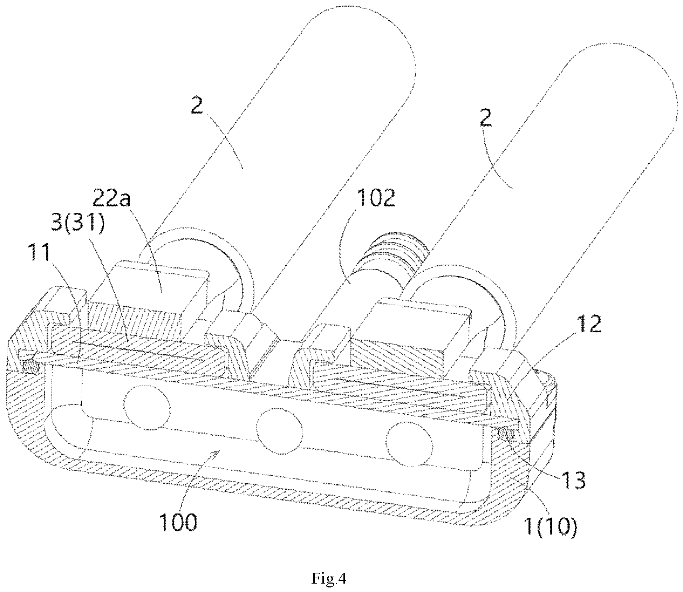

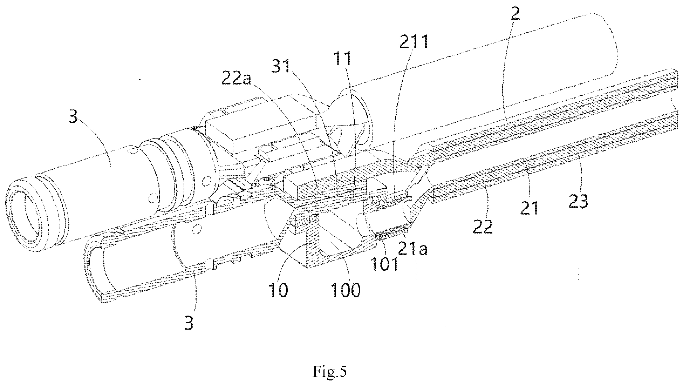

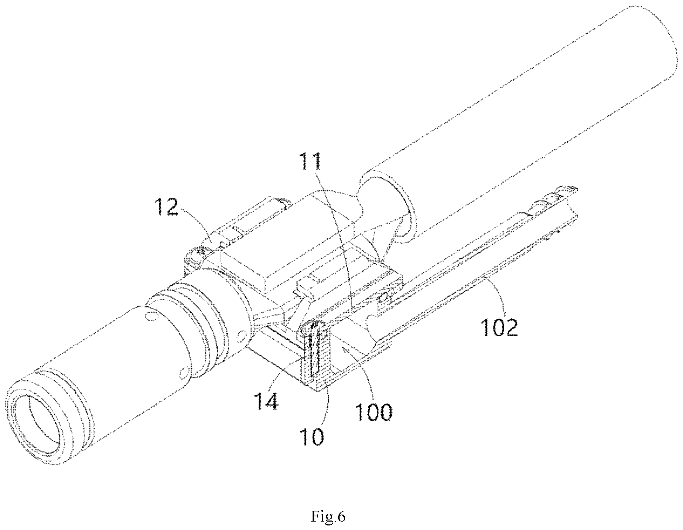

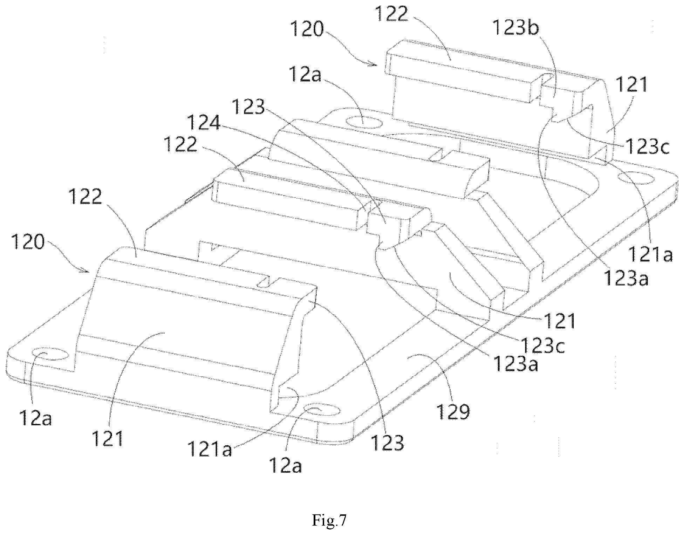

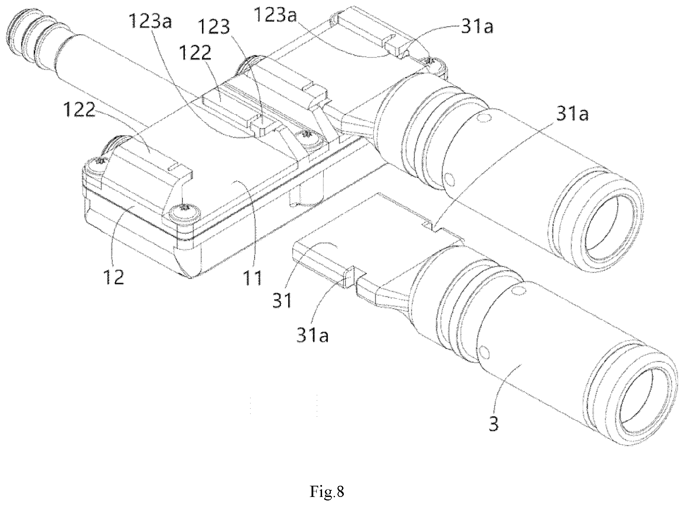

Figure 1 shows an illustrative perspective view of a charging terminal cooling box 1 according to an exemplary embodiment of the present invention when viewed from the bottom, wherein charging terminal 3 and charging cable 2 are shown; Figure 2 shows an illustrative perspective view of a charging terminal cooling box 1 according to an exemplary embodiment of the present invention when viewed from the top, wherein charging terminal 3 and charging cable 2 are shown; Figure 3 shows an illustrative exploded view of the charging terminal cooling box 1, charging terminal 3, and charging cable 2 according to an exemplary embodiment of the present invention; Figure 4 shows a transverse sectional view of a charging terminal cooling box 1, a charging terminal 3, and a charging cable 2 according to an exemplary embodiment of the present invention; Figure 5 shows a longitudinal sectional view of a charging terminal cooling box 1, a charging terminal 3, and a charging cable 2 according to an exemplary embodiment of the present invention; Figure 6 shows a longitudinal sectional view of a charging terminal cooling box 1 according to an exemplary embodiment of the present invention; Figure 7 shows an illustrative perspective view of a charging terminal fixing component 12 according to an exemplary embodiment of the present invention; Figure 8 shows an illustrative perspective view of a charging terminal cooling box 1 and a charging terminal 3 according to an exemplary embodiment of the present invention.

As shown in Figures 1 to 8, in an exemplary embodiment of the present invention, a charging terminal fixing component 12 is disclosed. The charging terminal fixing component 12 includes a frame 129 and a fixing structure 120. The frame 129 is adapted to be fixed to the charging terminal cooling box 1. The fixing structure 120 is formed on the top of the frame 129, used to fix the charging terminal 3 to the charging terminal cooling box 1.

As shown in Figures 1 to 8, in the illustrated embodiment, the fixing structure 120 includes a pair of side plates 121, a pair of top plates 122, and a pair of elastic buckles 123. The bottom of the pair of side plates 121 is connected to the top of the frame 129. The pair of top plates 122 are connected to the top of the pair of side plates 121. The pair of elastic buckles 123 are respectively connected to the top of the pair of side plates 121. The pair of top plates 122 are suitable to rest against the top surface of the welding end 31 of the charging terminal 3 inserted between the pair of side plates 121, so that the bottom surface of the welding end 31 of the charging terminal 3 is in thermal contact with the top cover 11 of the charging terminal cooling box 1. The pair of elastic buckles 123 are used to engage with a pair of snap slots 31 on the welding end 31 of the charging terminal 3, respectively, to lock the welding end 31 of the charging terminal 3 to the top cover 11 of the charging terminal cooling box 1. In the present invention, the pair of elastic buckles 123 can be driven to the unlocking position separated from the pair of snap slots 31a by a tool. Therefore, the welding end 31 of the charging terminal 3 can be easily removed from the charging terminal cooling box 1, making it very convenient to use.

As shown in Figures 1 to 8, in the illustrated embodiment, the pair of top plates 122 of the fixing structure 120 are located between the pair of side plates 121 and are spaced apart from each other by a predetermined distance to avoid the front end 22 of the conductor 22 of the charging cable 2 welded to the welding end 31 of the charging terminal 3. In the illustrated embodiment, the welding end 31 of the charging terminal 3 and the front end 22a of the conductor 22 of the charging cable 2 are both flat, and the width of the front end 22a of the conductor 22 of the charging cable 2 is smaller than the width of the welding end 31 of the charging terminal 3 and smaller than the spacing between the pair of top plates 122.

As shown in Figures 1 to 8, in the illustrated embodiment, the pair of elastic buckles 123 of the fixing structure 120 are respectively located at one ends of the pair of top plates 122, and a spacing slot 124 is formed between the elastic buckle 123 and one end of the top plate 122 to separate them.

As shown in Figures 1 to 8, in the illustrated embodiment, the elastic buckle 123 has a main body 123b that is flush with the top plate 122, and a protruding portion 123a that protrudes from the bottom of the main body 123b. The protruding portion 123a is used to engage with the snap slot 31a on the welding end 31 of the charging terminal 3.

As shown in Figures 1 to 8, in the illustrated embodiment, a guide slope 123c inclined with the top plate 122 is formed on the bottom of the elastic buckle 123 to guide the welding end 31 of the charging terminal 3 to be inserted between the top cover 11 of the charging terminal cooling box 1 and the top plates 122.

As shown in Figures 1 to 8, in the illustrated embodiment, the bottom of at least one of the pair of side plates 121 is formed with a wall recess 121a for joining with the edge of the top cover 11 of the charging terminal cooling box 1, in order to increase the bonding strength between the charging terminal fixing component 12 and the top cover 11 of the charging terminal cooling box 1.

As shown in Figures 1 to 8, in the illustrated embodiment, the charging terminal fixing component 12 includes multiple fixing structures 120, which are arranged side by side to respectively fix multiple charging terminals 3. In the illustrated embodiment, the charging terminal fixing component 12 includes two fixing structures 120 for respectively fixing two charging terminals 3.

As shown in Figures 1 to 8, in the illustrated embodiment, a mounting hole 12a is formed in the frame 129 of the charging terminal fixing component 12 to allow a connecting member 14 to pass through, so that the frame 129 can be fastened to the top surface 10b of the box body 10 of the charging terminal cooling box 1 through the connecting member 14 passing through the mounting hole 12a.

As shown in Figures 1 to 8, in another exemplary embodiment of the present invention, a top cover assembly is also disclosed. The top cover assembly includes: a top cover 11 and the aforementioned charging terminal fixing component 12. The top cover 11 is used to be installed on the top of the box body 10 of the charging terminal cooling box 1, to cover the top opening 100a of the box body 10. The charging terminal fixing component 12 is directly formed onto the top cover 11 by embedding injection molding. The charging terminal fixing component 12 is used to fix the welding end 31 of the charging terminal 3 to the top surface of the top cover 11, so as to transfer the heat of the charging terminal 3 to the cooling liquid inside the charging terminal cooling box 1 through the top cover 11.

As shown in Figures 1 to 8, in the illustrated embodiment, the top surface of the frame 129 of the charging terminal fixing component 12 is joined to the bottom surface of the top cover 11, and a connecting hole 11a corresponding to the mounting hole 12a in the frame 129 is formed in the top cover 11, so that the top cover assembly can be fastened to the top surface 10b of the box body 10 of the charging terminal cooling box 1 through the connecting member 14 passing through the connecting hole 11a and the mounting hole 12a.

As shown in Figures 1 to 8, in the illustrated embodiment, the top cover 11 is an insulation component that can conduct heat but cannot conduct electricity. For example, in an exemplary embodiment of the present invention, the top cover 11 may be a ceramic component that can conduct heat but cannot conduct electricity.

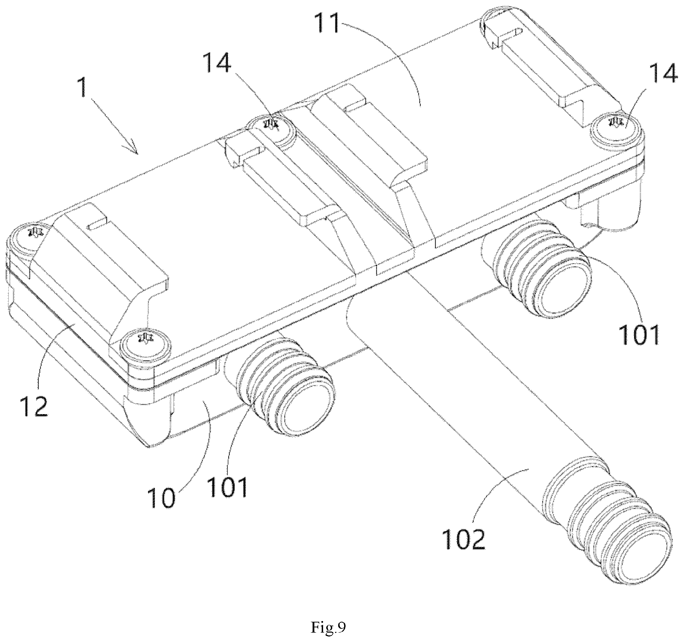

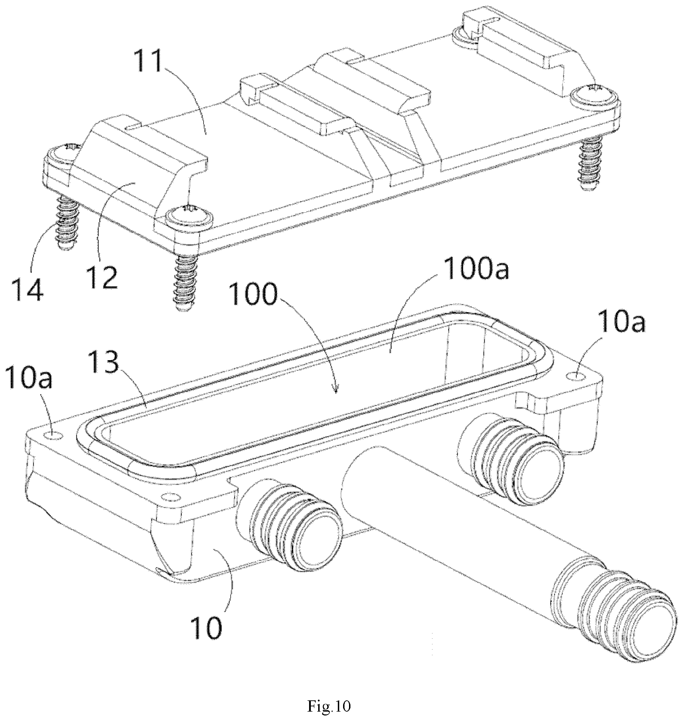

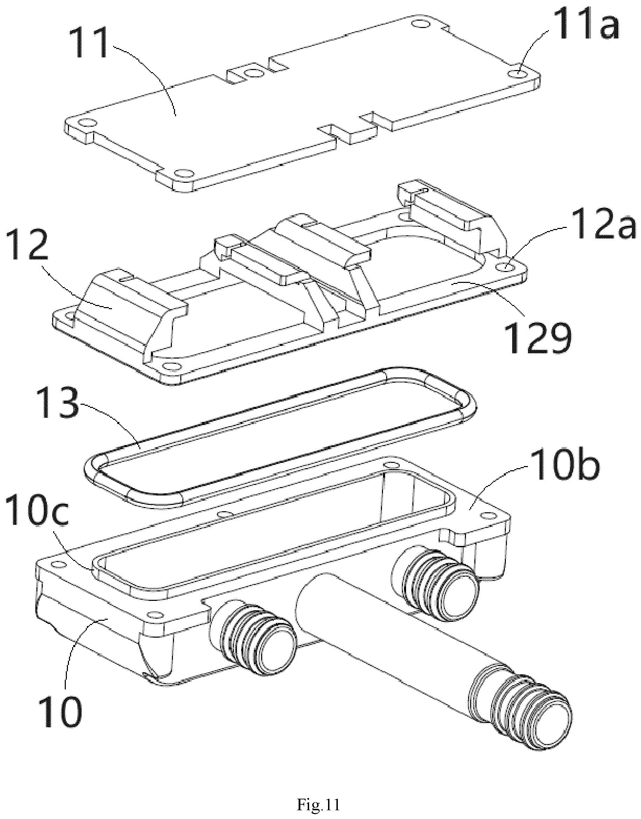

Figure 9 shows an illustrative perspective view of a charging terminal cooling box 1 according to an exemplary embodiment of the present invention; Figure 10 shows an illustrative perspective view of a charging terminal cooling box 1 according to an exemplary embodiment of the present invention, with the top cover assembly opened; Figure 11 shows an illustrative exploded view of a charging terminal cooling box 1 according to an exemplary embodiment of the present invention.

As shown in Figures 1 to 11, in another exemplary embodiment of the present invention, a charging terminal cooling box 1 is also disclosed. The charging terminal cooling box 1 includes a box body 10 and the aforementioned top cover assembly. The box body 10 has an inner cavity 100 for accommodating the cooling liquid and a top opening 100a. The top cover assembly is installed on the top of the box body 10 to cover the top opening 100a of the box body 10. The box body 10 has a cooling core pipe joint 101 and an inlet pipe joint 102 that are communicated with the inner cavity 100. The inlet pipe joint 102 is used to connect with an inlet pipe (not shown), and the cooling core pipe joint 101 is used to connect with an cooling core pipe 21 of the charging cable 2, so that the cooling liquid can flow through the charging terminal cooling box 1 and the cooling core pipe 21 of the charging cable 2 to cool the charging terminal 3 and the charging cable 2.

As shown in Figures 1 to 11, in the illustrated embodiment, the charging terminal cooling box 1 further comprises a sealing ring 13, which is arranged on the top of the box body 10 and surrounds the top opening 100a of the box body 10. The sealing ring 13 is compressed between the top cover 11 of the charging terminal cooling box 1 and the box body 10 to seal the top opening 100a of the box body 10.

As shown in Figures 1 to 11, in the illustrated embodiment, a flange portion 10c is formed on the top surface of the box body 10 to surround the top opening 100a, and the frame 129 of the charging terminal fixing component 12 surrounds the flange portion 10c. The sealing ring 13 is installed and positioned in an annular gap between the flange portion 10c of the housing 10 and the frame 129 of the charging terminal fixing component 12.

As shown in Figures 1 to 11, in the illustrated embodiment, a threaded hole 10a is formed in the top surface 10b of the box body 10 of the charging terminal cooling box 1. The charging terminal cooling box 1 also includes a connecting member 14. The connecting member 14 is a screw. The connecting member 14 passes through the connecting hole 11a in the top cover 11 and the mounting hole 12a in the charging terminal fixing component 12, and is threaded into the threaded hole 10a in the top surface 10b of the box body 10 to fasten the top cover assembly to the top surface 10b of the box body 10.

As shown in Figures 1 to 11, in the illustrated embodiment, the top cover 11 of the charging terminal cooling box 1 is an insulation component that can conduct heat but cannot conduct electricity. The box body 10 of the charging terminal cooling box 1 is an insulation component that is neither thermally conductive nor electrically conductive.

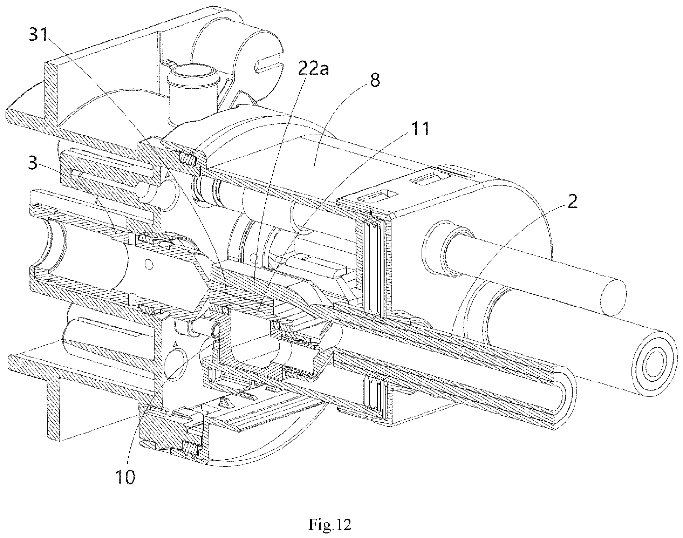

Figure 12 shows a longitudinal sectional view of a charging seat according to an exemplary embodiment of the present invention.

As shown in Figures 1 to 12, in another exemplary embodiment of the present invention, a charging seat is also disclosed. The charging seat includes: a housing 8, a charging terminal 3, a charging cable 2, and the charging terminal cooling box 1. The charging terminal 3 is arranged in the housing 8 and has a flat welding end 31. One end of charging cable 2 extends into housing 8. The charging cable 2 includes a cooling core pipe 21 and a conductor 22. The charging terminal cooling box 1 is set in the housing 8. The welding end 31 of the charging terminal 3 is fixed to the top surface of the top cover 11 of the charging terminal cooling box 1 by the charging terminal fixing component 12, and the front end 22 of the conductor 22 of the charging cable 2 is welded to the top surface of the welding end 31 of the charging terminal 3. The end portion of the cooling core pipe 21 of the charging cable 2 is connected to the cooling core pipe joint 101 of the box body 10 of the charging terminal cooling box 1, so that the cooling liquid can flow through the charging terminal cooling box 1 and the cooling core pipe 21 of the charging cable 2.

As shown in Figures 1 to 12, in the illustrated embodiment, the conductor 22 of the charging cable 2 is tubular, the cooling core pipe 21 is set in the conductor 21, and the charging cable 2 also includes an outer insulation layer 23 wrapped around the outside of the conductor 21.

As shown in Figures 1 to 12, in the illustrated embodiment, the welding end 31 of the charging terminal 3 is located within the coverage area of the top opening 100a of the box body 10 of the charging terminal cooling box 1, so that the heat of the entire welding end 31 can be transferred to the cooling liquid inside the charging terminal cooling box 1 through the top cover 11.

As shown in Figures 1 to 12, in the illustrated embodiment, the charging seat further includes a heat shrink tube 211, which is fitted and heat shrunk onto the end portion 21a of the cooling core pipe 21 and the cooling core pipe joint 101 of the charging terminal cooling box 1 to achieve a sealed connection between the cooling core pipe 21 and the cooling core pipe joint 101.

As shown in Figures 1 to 12, in the illustrated embodiment, the charging seat further comprises an inlet pipe (not shown), which is connected to the inlet pipe joint 102 of the charging terminal cooling box 1, for supplying cooling liquid to the charging terminal cooling box 1 and the cooling core pipe 21 of the charging cable 2.

As shown in Figures 1 to 12, in another exemplary embodiment of the present invention, a charging terminal cooling box 1 is also disclosed. The charging terminal cooling box 1 includes a box body 10 and a top cover 11. The box body 10 has an inner cavity 100 for accommodating the cooling liquid and a top opening 100a. The top cover 11 is installed on the top of the box body 10, used to cover the top opening 100a of the box body 10. The top cover 11 is used to make thermal contact with the welding end 31 of the charging terminal 3 fixed on it, in order to transfer the heat of the charging terminal 3 to the cooling liquid inside the box body 10. The box body 10 has a cooling core pipe joint 101 and an inlet pipe joint 102 that are communicated with the inner cavity 100. The inlet pipe joint 102 is used to connect with the inlet pipe, and the cooling core pipe joint 101 is used to connect with the cooling core pipe 21 of the charging cable 2, so that the cooling liquid can flow through the charging terminal cooling box 1 and the cooling core pipe 21 of the charging cable 2 to cool the charging terminal 3 and the charging cable 2.

As shown in Figures 1 to 12, in the illustrated embodiment, when the welding end 31 of the charging terminal 3 is fixed to the top cover 11, the welding end 31 of the charging terminal 3 is located within the coverage area of the top opening 100a of the box body 10, so that the heat of the entire welding end 31 can be transferred to the cooling liquid inside the box body 10 through the top cover 11.

As shown in Figures 1 to 12, in the illustrated embodiment, the charging terminal cooling box further includes a charging terminal fixing component 12, which is installed on the top of the box body 10 for fixing the welding end 31 of the charging terminal 3 to the top cover 11.

As shown in Figures 1 to 12, in the illustrated embodiment, the charging terminal fixing component 12 is directly formed onto the top cover 11 in an embedded injection molding manner, so that the charging terminal fixing component 12 and the top cover 11 become an integral piece.

As shown in Figures 1 to 12, in the illustrated embodiment, the charging terminal fixing component 12 includes a frame 129 and a fixing structure 120. The frame 129 is adapted to be fixed to the top of the box body 10. The fixing structure 120 is formed on the top of the frame 129. The fixing structure 120 includes a pair of side plates 121, a pair of top plates 122, and a pair of elastic buckles 123. The bottom of the pair of side plates 121 is connected to the top of the frame 129. The pair of top plates 122 are connected to the top of the pair of side plates 121. The pair of elastic buckles 123 are respectively connected to the top of the pair of side plates 121. The pair of top plates 122 are adapted to rest against the top surface of the welding end 31 of the charging terminal 3 inserted between the pair of side plates 121, so that the bottom surface of the welding end 31 of the charging terminal 3 is in thermal contact with the top cover 11. The pair of elastic buckles 123 are used to engage with a pair of snap slots 31a on the welding end 31 of the charging terminal 3, respectively, to lock the welding end 31 of the charging terminal 3 to the top cover 11.

As shown in Figures 1 to 12, in the illustrated embodiment, the pair of top plates 122 of the fixing structure 120 are located between the pair of side plates 121 and are spaced apart from each other by a predetermined distance to avoid the front end 22 of the conductor 22 of the charging cable 2 welded to the welding end 31 of the charging terminal 3.

As shown in Figures 1 to 12, in the illustrated embodiment, the pair of elastic buckles 123 of the fixing structure 120 are respectively located at one ends of the pair of top plates 122, and a spacing slot 124 is formed between the elastic buckle 123 and one end of the top plate to separate them.

As shown in Figures 1 to 12, in the illustrated embodiment, the elastic buckle 123 has a main body 123b that is flush with the top plate 122, and a protruding portion 123a that protrudes from the bottom of the main body 123b. The protruding portion 123a is used to engage with the snap slot 31a on the welding end 31 of the charging terminal 3.

As shown in Figures 1 to 12, in the illustrated embodiment, a guide slope 123c inclined with respect to the top plate 122 is formed at the bottom of the elastic buckle 123 to guide the welding end 31 of the charging terminal 3 to be inserted between the top cover 11 of the charging terminal cooling box 1 and the top plates 122.

As shown in Figures 1 to 12, in the illustrated embodiment, at least one bottom of the pair of side plates 121 is formed with a wall recess 121a for joining with the edge of the top cover 11 of the charging terminal cooling box 1, in order to increase the bonding strength between the charging terminal fixing component 12 and the top cover 11 of the charging terminal cooling box 1.

As shown in Figures 1 to 12, in the illustrated embodiment, the charging terminal fixing component 12 includes multiple fixing structures 120, which are arranged side by side to respectively fix the welding ends 31 of multiple charging terminals 3.

As shown in Figures 1 to 12, in the illustrated embodiment, the top surface of the frame 129 of the charging terminal fixing component 12 is joined to the bottom surface of the top cover 11, and a mounting hole 12a is formed in the frame 129. A threaded hole 10a and a connecting hole 11a corresponding to the mounting hole 12a in the frame 129 are respectively formed in the top surface 10b of the box body 10 and the top cover 11. The charging terminal cooling box 1 also includes a connecting member 14, which sequentially passes through the connecting hole 11a and the mounting hole 12a and is threaded into the threaded hole 10a to fasten the top cover 11 and the charging terminal fixing component 12 to the top surface 10b of the box body 10.

As shown in Figures 1 to 12, in the illustrated embodiment, the top cover 11 is an insulation component that can conduct heat but cannot conduct electricity. For example, the top cover 11 can be a ceramic component that can conduct heat but cannot conduct electricity.

As shown in Figures 1 to 12, in the illustrated embodiment, the box body 10 is an insulation component that is neither thermally conductive nor electrically conductive.

As shown in Figures 1 to 12, in the illustrated embodiment, the charging terminal cooling box 1 further comprises a sealing ring 13, which is arranged on the top of the box body 10 and surrounds the top opening 100a of the box body 10. The sealing ring 13 is compressed between the top cover 11 and the box body 10 to seal the top opening 100a of the box body 10.

As shown in Figures 1 to 12, in the illustrated embodiment, a flange portion 10c is formed on the top surface of the box body 10 to surround the top opening 100a, and the frame 129 of the charging terminal fixing component 12 surrounds the flange portion 10c. The sealing ring 13 is installed and positioned in an annular gap between the flange portion 10c of the housing 10 and the frame 129 of the charging terminal fixing component 12.

As shown in Figures 1 to 12, in another exemplary embodiment of the present invention, a charging seat is also disclosed. The charging seat includes: a housing 8, a charging terminal 3, a charging cable 2, and a charging terminal cooling box 1. The charging terminal 3 is arranged in the housing 8 and has a flat welding end 31. One end of charging cable 2 extends into the housing 8. The charging cable 2 includes a cooling core pipe 21 and a conductor 22. The charging terminal cooling box 1 is set in the housing 8. The welding end 31 of the charging terminal 3 is fixed to the top surface of the top cover 11 of the charging terminal cooling box 1, and the front end 22 of the conductor 22 of the charging cable 2 is welded to the top surface of the welding end 31 of the charging terminal 3. The end portion of the cooling core pipe 21 of the charging cable 2 is connected to the cooling core pipe joint 101 of the box body 10 of the charging terminal cooling box 1, so that the cooling liquid can flow through the charging terminal cooling box 1 and the cooling core pipe 21 of the charging cable 2.

As shown in Figures 1 to 12, in the illustrated embodiment, the charging seat includes a heat shrink tube 211, which is fitted and heat shrunk onto the end portion 21a of the cooling core pipe 21 and the cooling core pipe joint 101 of the charging terminal cooling box 1 to achieve a sealed connection between the cooling core pipe 21 and the cooling core pipe joint 101.

As shown in Figures 1 to 12, in the illustrated embodiment, the charging seat includes an inlet pipe (not shown), which is connected to the inlet pipe joint 102 of the charging terminal cooling box 1, for supplying cooling liquid to the charging terminal cooling box 1 and the cooling core pipe 21 of the charging cable 2.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A charging terminal fixing component, comprising:
a frame (129) adapted to be fixed to a charging terminal cooling box (1); and
a fixing structure (120) which is formed on the top of the frame (129) for fixing a charging terminal (3) to the charging terminal cooling box (1),
wherein the fixing structure (120) comprises:
a pair of side plates (121), with their bottom connected to the top of the frame (129);
a pair of top plates (122) respectively connected to the top of the pair of side plates (121); and
a pair of elastic buckles (123) respectively connected to the top of the pair of side plates (121),
wherein the pair of top plates (122) are adapted to rest against the top surface of a welding end (31) of the charging terminal (3) inserted between the pair of side plates (121), so that the bottom surface of the welding end (31) of the charging terminal (3) is in thermal contact with a top cover (11) of the charging terminal cooling box (1),
wherein the pair of elastic buckles (123) are used to respectively engage with a pair of snap slots (31a) on the welding end (31) of the charging terminal (3), to lock the welding end (31) of the charging terminal (3) to the top cover (11) of the charging terminal cooling box (1).

2. The charging terminal fixing component according to claim 1,
wherein the pair of top plates (122) of the fixing structure (120) are located between the pair of side plates (121) and are spaced apart from each other by a predetermined distance, used to avoid a front end (22) of a conductor (22) of a charging cable (2) welded to the welding end (31) of the charging terminal (3).

3. The charging terminal fixing component according to claim 1,
wherein the pair of elastic buckles (123) of the fixing structure (120) are respectively located at one ends of the pair of top plates (122), and a spacing slot (124) is formed between the elastic buckle (123) and one end of the top plate to separate them.

4. The charging terminal fixing component according to claim 3,
wherein the elastic buckle (123) has a main body (123b) that is flush with the top plate (122) and a protruding portion (123a) that protrudes from the bottom of the main body (123b), the protruding portion (123a) is used to engage with the snap slot (31a) on the welding end (31) of the charging terminal (3).

5. The charging terminal fixing component according to claim 4,
wherein a guide slope (123c) inclined with the top plate (122) is formed on the bottom of the elastic buckle (123) to guide the welding end (31) of the charging terminal (3) to be inserted between the top cover (11) of the charging terminal cooling box (1) and the top plates (122).

6. The charging terminal fixing component according to claim 1,
wherein a wall recess (121a) is formed at the bottom of at least one of the pair of side plates (121), for joining with the edge of the top cover (11) of the charging terminal cooling box (1), to increase the bonding strength between the charging terminal fixing component (12) and the top cover (11) of the charging terminal cooling box (1).

7. The charging terminal fixing component according to claim 1,
wherein the charging terminal fixing component (12) comprises multiple fixing structures (120) arranged side by side for fixing multiple charging terminals (3) respectively.

8. The charging terminal fixing component according to claim 1,
wherein a mounting hole (12a) is formed in the frame (129) to allow a connecting member (14) to pass through, so that the frame (129) can be fastened to the top surface (10b) of the charging terminal cooling box (1) through the connecting member (14) passing through the mounting hole (12a).

9. A top cover assembly, comprising:
a top cover (11) which is adapted to be installed on the top of a box body (10) of a charging terminal cooling box (1) to cover a top opening (10a) of the box body (10); and
the charging terminal fixing component (12) according to any one of claims 1-8 which is directly formed onto the top cover (11) by embedding injection molding,
wherein the charging terminal fixing component (12) is used to fix the welding end (31) of the charging terminal (3) to the top surface of the top cover (11), so as to transfer the heat of the charging terminal (3) to the cooling liquid inside the charging terminal cooling box (1) through the top cover (11).

10. The top cover assembly according to claim 9,
wherein the top surface of the frame (129) of the charging terminal fixing component (12) is joined to the bottom surface of the top cover (11), and a connection hole (11a) corresponding to the mounting hole (12a) on the frame (129) is formed in the top cover (11), so that the top cover assembly can be fastened to the top surface (10b) of the box body (10) of the charging terminal cooling box (1) by a connection member (14) passing through the mounting hole (12a) and the connection hole (11a).

11. The top cover assembly according to claim 9,
wherein the top cover (11) is an insulation component that can conduct heat but cannot conduct electricity.

12. A charging terminal cooling box, comprising:
a box body (10) which has an inner cavity (100) for accommodating cooling liquid and a top opening (100a); and
the top cover assembly according to any one of claims 9 to 11, installed on the top of the box body (10), for covering the top opening (10a) of the box body (10),
wherein the box body (10) has a cooling core pipe joint (101) and an inlet pipe joint (102) communicated with the inner cavity (100), the inlet pipe joint (102) is used to connect with an inlet pipe, and the cooling core pipe joint (101) is used to connect with a cooling core pipe (21) of a charging cable (2), so that the cooling liquid can flow through the charging terminal cooling box (1) and the cooling core pipe (21) of the charging cable (2) to cool the charging terminal (3) and the charging cable (2).

13. The charging terminal cooling box according to claim 12, further comprising:
a sealing ring (13) which is installed on the top of the box body (10) and surrounds the top opening (100a) of the box body (10),
wherein the sealing ring (13) is compressed between the top cover (11) and the box body (10) of the charging terminal cooling box (1) to seal the top opening (10a) of the box body (10).

14. The charging terminal cooling box according to claim 13,
wherein a flange portion (10c) is formed on the top surface of the box body (10) to surround the top opening (100a), and the frame (129) of the charging terminal fixing component (12) surrounds the flange portion (10c);
wherein the sealing ring (13) is installed and positioned in a annular gap between the flange portion (10c) of the box body (10) and the frame (129) of the charging terminal fixing component (12).

15. The charging terminal cooling box according to claim 12,
wherein the top cover (11) of the charging terminal cooling box (1) is an insulation component that conducts heat but not electricity, and the box body (10) of the charging terminal cooling box (1) is an insulation component that cannot conducts heat and electricity.

16. A charging seat, comprising:
a housing (8);
a charging terminal (3) which is provided in the housing (8) and has a flat welding end (31);
a charging cable (2), one end of which extends into the housing (8) and includes a cooling core pipe (21) and a conductor (22); and
the charging terminal cooling box (1) according to any one of claims 12 to 15 which is provided in the housing (8),
wherein the welding end (31) of the charging terminal (3) is fixed to the top surface of the top cover (11) of the charging terminal cooling box (1) by the charging terminal fixing component (12), and the front end (22a) of the conductor (22) of the charging cable (2) is welded to the top surface of the welding end (31) of the charging terminal (3),
wherein the end (21) of the cooling core pipe (21) of the charging cable (2) is connected to the cooling core pipe joint (101) of the box body (10) of the charging terminal cooling box (1), so that the cooling liquid can flow through the charging terminal cooling box (1) and the cooling core pipe (21) of the charging cable (2).

17. The charging seat according to claim 16,
wherein the welding end (31) of the charging terminal (3) is located within the coverage area of the top opening (100A) of the box body (10) of the charging terminal cooling box (1), so that the heat of the entire welding end (31) can be transferred to the cooling liquid inside the charging terminal cooling box (1) through the top cover (11).
